Europäisches Patentamt

European Patent Office

Office européen des brevets

(11) Publication number: **0 399 126 B1**

## EUROPEAN PATENT SPECIFICATION

(45) Date of publication of patent specification: **24.11.93**   (51) Int. Cl.5: **H03K 19/082**, H03K 19/086

(21) Application number: **89480054.9**

(22) Date of filing: **11.04.89**

(54) **Current source technology.**

(30) Priority: **23.05.88 US 197779**

(43) Date of publication of application:
**28.11.90 Bulletin 90/48**

(45) Publication of the grant of the patent:
**24.11.93 Bulletin 93/47**

(84) Designated Contracting States:
**BE CH DE ES FR GB IT LI NL SE**

(56) References cited:
**EP-A- 0 132 523**
**US-A- 4 605 870**

**IBM TECHNICAL DISCLOSURE BULLETIN, vol. 25. no. 9, February 1983, page 4834, New York, US; R.D. DUSSAULT et al.: "Push-pull logic circuit"**

**IBM TECHNICAL DISCLOSURE BULLETIN, vol.24, no. 11A, April 1982, pages 5613-5618, New York, US; A.H. DANSKY et al.: "Active pull-down circuit for current-controlled gate"**

(73) Proprietor: **International Business Machines Corporation**
**Old Orchard Road**
**Armonk, N.Y. 10504(US)**

(72) Inventor: **Gaudenzi, Gene Joseph**
**Oak Ridge Road**
**Purdys New York 10578(US)**

(74) Representative: **Schuffenecker, Thierry**
**Compagnie IBM France,**
**Département de Propriété Intellectuelle**
**F-06610 La Gaude (FR)**

EP 0 399 126 B1

**Description**

This invention pertains to semi conductor digital circuit.

Background Information

Prior Art

U.S. Patent No. 4,605,870 of Dansky and Norsworthy for "High Speed Low Power Current Controlled Gate Circuit" shows six NPN transistors, a resistor, and a low barrier Schottky diode LB connected in three variations of a circuit. In each case the lower output transistor in a push-pull arrangement has its collector driven by a PNP transistor with its base shorted to its emitter which serves as a base-to-collector diode which enables capacitive coupling of the input signal to the base of the lower output transistor in the push-pull output section. The base-to-collector diode PNP transistor carries a substantial amount of current, which can be reduced employing the circuit of this invention.

An object of this invention is to use of current source technology to obtain high performance (less than 1 nsec delay) bipolar circuits at low power dissipation. The gate circuit of this invention offers excellent power dissipation characteristics. A gate circuit in accordance with this invention offers an excellent speed times power product, one competitive with CMOS and BICMOS, in gate array product programs employing +5 Volt and 0 Volt power supplies.

Brief Description of the Drawings

FIG. 1 shows a gate circuit employing NPN transistors connected in a circuit in accordance with this invention.
FIG. 2 shows a modification of FIG. 1.

Description of the Preferred Embodiments

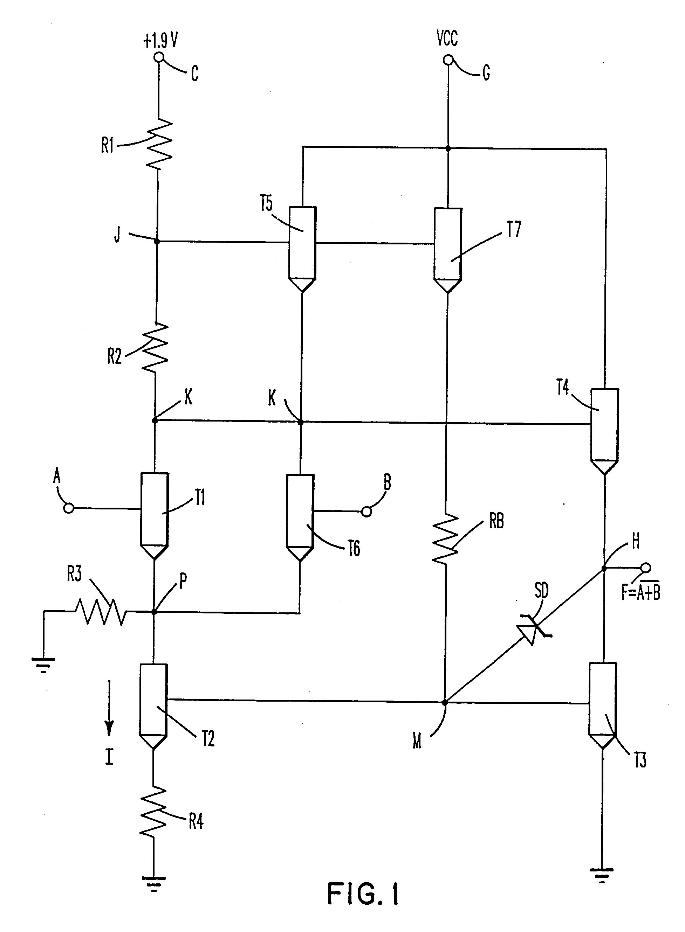

FIG. 1 shows a circuit in accordance with this invention including a set of seven NPN transistors T1-T7, Schottky diode SD, resistors R1 to R4 and RB, Bterminal C, and VCC terminal G. None of the transistors has its base-emitter circuit shorted out as in Dansky et al above and the signal is connected from the input section to the output section direct ly from the base of a transistor T2 in the input circuit to the base of the lower output transistor T3. Transistor T2 is connected with its collector emitter connections in parallel with the emitter resistor R3 of the input transistors T1 and T6 which receive the input signals to the circuit at terminals A and B. The input section comprises transistors T1, T2, T5, T6 and T7. Transistors T1 and T6 are connected to input terminals A and B to provide a possible NOR arrangement although one of T1 and T6 alone can be provided if the requirement of the circuit is simply for an inverter circuit. The transistors T2, T5, and T7 complete the five transistor input section. Transistors T3 and T4 comprise the push-pull output section. Transistor T4 serves as a pull-up emitter follower. Diode SD provides capacitive coupling from the base of transistor T3 to its collector.

Resistor R1 is connected between B+ potential of 1.9 Volts at terminal C and node J which is connected to the base of transistor T5 and to the upper end of resistor R2. The opposite end of resistor R2 is connected through node K to the collector of transistor T1. The base of transistor T1 is connected to one of the input terminals A of the circuit of FIG. 1, which is one of the two input terminals A and B for the circuit of FIG. 1. The emitter of transistor T1 is connected along with the emitter of transistor T6 through node P to one end of resistor R3 which connects at its opposite end to ground. Node P also connects to the collector of transistor T2. The emitter of transistor T2 is connected though resistor R4 to ground. Node G is connected between voltage source VCC and the collectors of transistors T4, T5, and T7. The bases of transistors T5 and T7 are both connected to the node J between resistors R1 and R2 to receive the voltage set by transistors T1 and T6 in response to their base voltages set by inputs on terminals A and B. The emitter of transistor T5 is connected via node K to the collectors of transistors T1 and T6 and to the base of output transistor T4. As indicated above, the collector of transistor T6 is connected to node K, the base is connected to input terminal B and the emitter is connected to node P. The collector of transistor T2 is also connected to node P through which current IR4 passes via transistor T2. The base of tran sistor T2 is connected to node M, and its emitter is connected to the upper end of resistor R4, whose opposite end is connected to ground. The emitter of transistor T7 is connected via resistor RB to node M. Node M connects to the bases of transistors T2 and T3. In addition, node M is connected by Schottky diode SD to node H, which is connected to the output terminal F of the circuit of FIG. 1. Transistor T4 has its collector connected to terminal G, its base to node K, and its emitter to node H. Transistor T3 has its collector connected to node H its base to node M and its emitter to ground. The circuit comprises a NOR circuit with the output signal (A + B bar) at the output terminal F in response to the input signals A and B. Transistors T3 and T4 are connected in a push-pull arrangement. The digital NOR gate of FIG. 1 is designed to operate with the transistors T2, T3, T4, T5, and T7 always remaining on with the current levels varying between high and low levels as a function of input signal levels at input terminals A and B to provide higher speeds of operation of the output transistor T4 in response to an input at terminal A or B. Note that the the NOR output at terminal F is as follows:

$$F = \overline{A + B}$$

The current source gate circuit shown in FIG. 1 features a push-pull output stage, comprising transistors T3 and T4, that is dottable, i.e. the output signals of two such circuits can be connected together without disturbing the performance of either circuit dotted to the other.

When the input terminal A is down at a low voltage (0.2 V), transistor T1 must be off, causing transistor T4 to conduct, thus establishing a binary "one" level (about 1.2V). Transistor T7 senses the voltage divider such that about 10 microamperes bias current is available for a resistor RB value of about 40k ohms to transistor T2 and output transistor T3. Because the voltage on the collection of transistor T2 is at ground level, it will saturate, which is critical to the fall transition on the output.

When the voltage at input A rises, T1 will turn on fast, causing current to flow from its base through resistor R3 and the collector of transistor T2. The voltage at the base of T2 then rises quickly, as indicated by the expression, as follows:

$$V_{B_{T2}} = V_{BE_{T2}} + I_{T2} * R4.$$

The $I_{T2}$ current spike generated is critical for raising the potential at the T2 emitter, which is required to produce the desired rapid increase in

$$V_{B_{T2}}$$

which raises the voltage on node M in response to the current spike. The voltage on node M raises the potential on the base of transistor T3, turning it on. The transistor T5 is employed to enhance the value of the $I_{T2}R$ current spike by assuring that the voltage on the collector of transistor T1 does not drop too low, leading to saturation. Once the output falls to a low value (about 0.25V), and transistor T1 is on in the active region, the transistor T7 emitter current drops low enough to keep the power low in response to the IR drop across the divider of resistors R1 from node C to node J and resistors R2 and R3 from node J to ground. It should be noted that the transistor T1 gain is adjusted so that in the down level of transistor T4 is allowed to conduct (about 40 microamperes), assuring good speed when pulling up. The power consumed by the circuit in the down level of node F will be dependent on the current into ground [ $I_{GND}$], as defined by the expression:

$$I_{GND} \text{ (down)} = I_{R3} + I_{R4} + I_{EE}(T3),$$

where $I_{R4}$ = D.C. current and $I_{EE}$ is the T3 emitter current. $I_{EE}(T3)$ is high for only a very short time, thereby reducing the power consumption of this circuit.

The value of resistor R2 is chosen such as to assure the output down level, i.e.,

$$Gain = (R_1 + R_2)/R3,$$

causing I to be very low in value (about 30 microamperes). The current $I_{EE}(T3)$ is dependent on the emitter area of the transistor T3 and is also kept to a low value. A key design consideration with this circuit is to make the T2 emitter area as large as possible so that, in the D. C. case, the least current is mirrored to transistor T3. As noted earlier, the current $I_{R4}$ (D. C. current) is critical for current spike generation. As a current spike is generated, the voltage represented by the IR drop (I*R4 product) is responsible for causing a current spike in T3.

Up level operation is achieved by decreasing the voltage on input terminal A such that transistor T1 turns off thereby allowing the voltage on the base of transistor T4 to rise. Output at terminal F will then sit at an up level value of +1.2V. Collector dotting of the push-pull signal at output terminal F may be achieved because the zero level is the non-controlling state. Down level current in output transistor T3 is limited to about 0.5 microamperes max. because of the mirror effect of transistors T2 and T3 and a reduction in the available base current $I_{RB}$ to transistors T3 and T4.

The gate circuit shown may be extended for opera-tion into advanced transistor technologies, including BICMOS, by applying the concept of the disclosed current source arrangement(T7, T2 and T3) to establish the complementary output of transistors T3 and T4.

All the transistors in FIG. 1 are NPN transistors. The resistor R1 has a value of about 1.75 kohm, R2 has a value of about 1.25 kohm, resistor R3 has a value of about 2 kohm, R4 has a value of about 0.5 kohm, and RB has a value of about 40 kohm. Voltage VCC has a value of about 5.0 volts but can be in a range from 1.9 to 5.0 volts.

Operation of Circuit

A = 1

Assume that A has a binary value of "1".
Terminal A is positive in value, at about 1.2 volts and transistor T1 is ON. The voltage divider (R1 + R2)/R3 keeps T4 conducting while T3 is conducting. R1 + R2 = 3 kohm and R3 = 2kohm. Normally one would expect a large amount of current in T3, but node K is held low at about 1 to 1.2 volts by T1 conducting to hold T3 at low current as the current through transistor T7 and RB is low, as explained above. The voltage at node P is about 0.4 Volts. Transistor T1 which is turned on has a voltage drop across the collector emitter circuit of about 0.15 Volts.

A = 0

Assume that T1, T3, T2 and T4 are on when A drops to "0". T1 turns off immediately so node K rises to about 1.9 volts so T4 turns on more and node F is then at 1.2 Volts. Since node K has risen to about 1.9 volts node J rises to raise current through transistor T7 which passes through resistor RB and node M. The current into node M splits there and passes through the base input circuits of T2 and T3. Resistor RB is large enough to limit the current into node M. Thus T2 and T3 remain conduct ing with T2 saturated and T3 conducts a low current, operating in a quiescent state, since the limited current through RB is split between T2 and T3.

A = 1 again

Node A rises again and turns T1 on quickly. Therefore there is a shot of current which passes through R3 causing node P to rise. Also, increased current through R4 raises the emitter and base poten-tials on T2, raising node M to turn on T3 quickly so output terminal F is pulled down fast to about 0.1 volts from 1.2 volts. Again R1 and R2 in the divider circuit with R3 provide potentials which hold current in T2 down, with the IR drop across R4 holding current down, by raising emitter potential of T2.

TABLE I

| High and Low Voltage Levels for Nodes of Circuit | | |
|---|---|---|
| Node | High | Low |
| A | 1.2 Volts | 0.2 Volts |
| F | 1.2 | 0.1 |
| K | 1.9 | 1.0 |
| M | 0.8 | 0.8 |
| P | 0.4 | 0.0 |

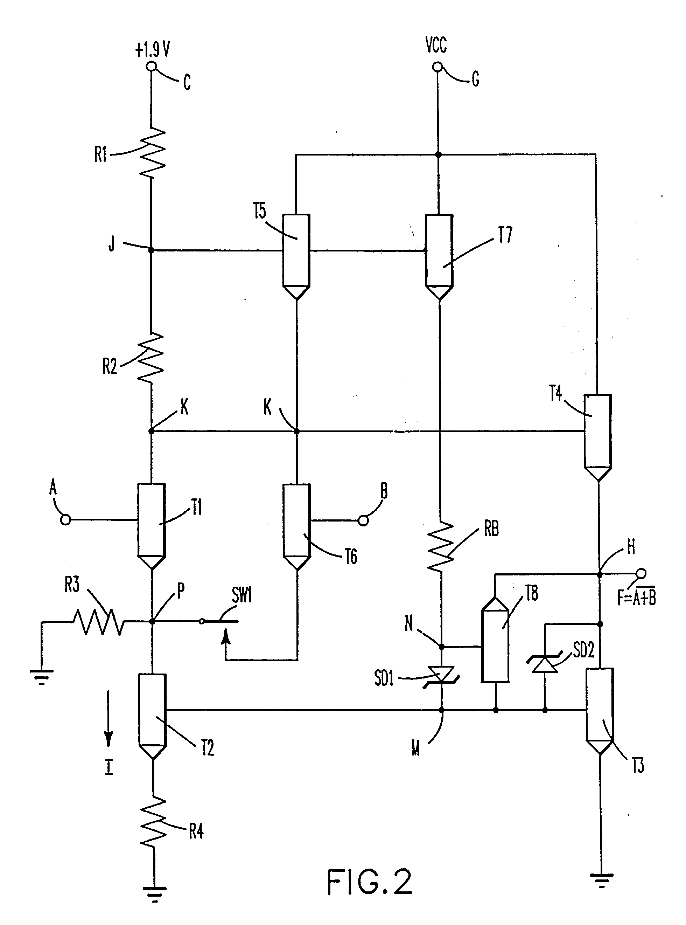

FIG. 2. shows a modification of the circuit of FIG. 1 in the form of an inverter circuit which can be used as a gate if desired as in FIG. 1. The switch SW1 has been added to make it clear that the transistor T6 can be included in the circuit when it is desired to have a gate circuit.

The second modification of FIG. 2 is that the resistor RB is connected to the node N, instead of node M. Node N is connected to node M by an NPN transistor T8 with its base connected to node N, and its collector connected to node M, plus a Schottky diode SD1 in its base collector circuit connected to conduct in the forward direction from node N to node M. The emitter of transistor T8 is connected to node H. In addition, transistor T3 includes a Schottky diode SD2 in its collector base circuit with the diode conducting in the forward direction from node M to node H. The operation of the circuit if FIG. 2 is the same as FIG. 1, with the exception that the voltage at node H and terminal F, when it is down is at a higher potential than in FIG. 1, with the potential at 0.7 Volts instead of 0.2 Volts.

## Claims

1. A high speed, low power, current-controlled logic circuit comprising:

   an input section comprising resistors R1, R2 and R3 and a transistor T1, said resistors R1, R2, the emitter/collector junction of transistor T1 and said resistor R3 being connected in series between a bias potential C and the ground potential, the base of transistor T1 being connected to an input terminal A; and

   said input section further comprising transistor T5 having a base connected to the common terminal J of resistors R1 and R2, a collector connected to a second bias potential G and an emitter which is connected to the common terminal K of resistor R2 and the collector of transistor T1; and

   said input section further comprising a transistor T6 having a base connected to an input terminal B, a collector being connected to terminal K and a emitter connected to the common junction P of resistor R3 and the emitter of transistor T1,

   an output section comprising two transistors T3 and T4 arranged in a push-pull fashion, said transistor T4 having a base connected to terminal K, a collector connected to terminal G and a emitter which is connected to the output terminal H of said output section;

   said transistor T3 having a collector connected to output terminal H, an emitter connected to the ground potential, and a base connected to a terminal M,

   characterized in that it further includes:

   a transistor T7 having a base connected to said terminal J, a collector connected to terminal G, and a emitter, and

   a resistor RB being connected between the emitter of said transistor T7 and said terminal M, and

   a transistor T2 having a base connected to said terminal M, a collector connected to said terminal P and an emitter,

   a resistor R4 being connected between the emitter of said transistor T2 and the ground potential,

   a first Schottky diode (SD,SD2) being connected between said terminal M and the output terminal H of said output section.

2. A circuit according to claim 1 characterized in that it further comprises a second Schottky diode SD1 being inserted between said resistor RB and said terminal M,

   a transistor T8 having a base connected to the common junction N of said resistor RB and said second Schottky diode SD1, an emitter connected to said output terminal H, and an collector connected to said terminal M.

**Patentansprüche**

1. Stromgesteuerte logische Schaltung mit niedriger Leistung und hoher Geschwindigkeit mit:

   einem Eingangsabschnitt, der Widerstände R1, R2 und R3 und einen Transistor T1 umfaßt, wobei die Widerstände R1, R2, die Emitter-Kollektor-Verbindung des Transistors T1 und der Widerstand R3 in Serie zwischen einem Vorspannungspotential C und dem Massepotential geschaltet sind, wobei die Basis des Transistors T1 mit einem Eingangsanschluß A verbunden ist; und

   der Eingangsabschnitt umfaßt ferner einen Transistor T5, der eine Basis, die mit dem gemeinsamen Anschluß J der Widerstände R1 und R2 verbunden ist, einen Kollektor, der an ein zweites Vorspannungspotential G angeschlossen ist, und einen Emitter aufweist, der mit dem gemeinsamen Anschluß K des Widerstandes R2 und dem Kollektor des Transistors T1 verbunden ist; und

   der Eingangsabschnitt umfaßt ferner einen Transistor T6, der eine Basis, die mit einem Eingangsanschluß B verbunden ist, einen Kollektor, der an den Anschluß K angeschlossen ist, und einen Emitter aufweist, der mit dem gemeinsamen Anschluß P des Widerstandes R3 und dem Emitter des Transistors T1 verbunden ist,

   einem Ausgangsabschnitt, der zwei Transistoren T3 und T4 umfaßt, die in einer Gegentaktschaltung angeordnet sind, wobei der Transistor T4 eine Basis, die mit dem Anschluß K verbunden ist, einen Kollektor, der mit dem Anschluß G verbunden ist, und einen Emitter aufweist, der mit dem Ausgangsanschluß H des Ausgangsabschnittes verbunden ist;

   wobei der Transistor T3 einen Kollektor, der mit dem Ausgangsanschluß H verbunden ist, einen Emitter, der an das Massepotential angeschlossen ist, und eine Basis aufweist, die mit einem Anschluß M verbunden ist, dadurch gekennzeichnet, daß sie ferner ausgestattet ist mit:

   einem Transistor T7, der eine Basis, die mit dem Anschluß J verbunden ist, einen Kollektor, der an den Anschluß G angeschlossen ist, und einen Emitter aufweist, und

   einem Widerstand RB, der zwischen dem Emitter des Transistors T7 und dem Anschluß M angeschlossen ist, und

   einem Transistor T2, der eine Basis, die mit dem Anschluß M verbunden ist, einen Kollektor, der an den Anschluß P angeschlossen ist, und einen Emitter aufweist,

   einem Widerstand R4, der zwischen dem Emitter des Transistors T2 und dem Massepotential angeschlossen ist,

   einer ersten Schottkydiode (SD, SD2), die zwischen dem Anschluß M und dem Ausgangsanschluß H des Ausgangsabschnittes angeschlossen ist.

2. Schaltung nach Anspruch 1, dadurch gekennzeichnet, daß sie ferner eine zweite Schottkydiode SD1, die zwischen dem Widerstand RB und dem Anschluß M eingefügt ist, und

   einen Transistor T8 umfaßt, der eine Basis, die mit dem gemeinsamen Anschluß N des Widerstandes RB und der zweiten Schottkydiode SD1 verbunden ist, einen Emitter, der mit dem Ausgangsanschluß H verbunden ist, und einen Kollektor aufweist, der mit dem Anschluß M verbunden ist.

**Revendications**

1. Circuit logique à haute vitesse et faible consommation, commandé en courant, comprenant :

   une section d'entrée comprenant des résistances R1, R2 et R3 et un transistor T1, lesdites résistances R1, R2, la jonction émetteur/collecteur du transistor T1 et ladite résistance R3 étant connectées en série entre un potentiel de polarisation C et le potentiel de la masse, la base du transistor T1 étant connectée à une borne d'entrée A ; et

   ladite section d'entrée comprenant en outre un transistor T5 ayant sa base connectée à la borne commune J des résistances R1 et R2, son collecteur connecté à un second potentiel de polarisation G et son émetteur connecté à la borne commune K de la résistance R2 et du collecteur du transistor T1 ; et

   ladite section d'entrée comprenant en outre un transistor T6 ayant sa base connectée à une borne d'entrée B, son collecteur étant connecté à la borne K et son émetteur étant connecté à la jonction commune P de la résistance R3 et de l'émetteur du transistor T1,

   une section de sortie comprenant deux transistors T3 et T4 disposés en push-pull, ledit transistor T4 ayant sa base connectée à la borne K, son collecteur connecté à la borne G et son émetteur connecté à la borne de sortie H de ladite section de sortie ;

   ledit transistor T3 ayant son collecteur connecté à la borne de sortie H, son émetteur connecté au potentiel de la masse, et sa base connectée à la borne M,

caractérisé en ce qu'il comporte en outre :

un transistor T7 ayant sa base connectée à ladite borne J, son collecteur connecté à la borne G, et un émetteur, et

une résistance RB étant connectée entre l'émetteur dudit transistor T7 et ladite borne M, et

un transistor T2 ayant sa base connectée à ladite borne M, son collecteur connecté à ladite borne P et à un émetteur,

une résistance R4 étant connectée entre l'émetteur dudit transistor T2 et le potentiel de la masse,

une première diode Schottky (SD, SD2) étant connectée entre ladite borne M et la borne de sortie H de ladite section de sortie.

2. Circuit selon la revendication 1, caractérisé en ce qu'il comporte en outre une seconde diode Schottky SD1 insérée entre ladite résistance RB et ladite borne M,

un transistor T8 ayant sa base connectée à la jonction commune N de ladite résistance RB et ladite diode Schottky SD1, un émetteur connecté à ladite borne de sortie H, et son collecteur connecté à ladite borne M.

FIG.1

FIG.2